# EUROPEAN PATENT SPECIFICATION

(11) **EP 2 161 527 B1**
(45) Date of publication and mention of the grant of the patent: **20.07.2011**
(21) Application number: 08015644.1
(22) Date of filing: 04.09.2008
(51) Int. Cl.: F28D 15/02, H01L 21/48, H01L 23/427

(54) **Process and assembly for flush connecting evaporator sections of juxtaposed heat pipes to a fixing base**
Verfahren zur Anordnung von Verdampferabschnitten bündig liegender Wärmerohre auf einer Befestigungsplatte und entsprechende Anordnung
Procédé et assemblage pour des sections d'évaporateur à connexion par affleurement de caloducs juxtaposés sur une base fixe

(43) Date of publication of application: 10.03.2010
(73) Proprietor: CPUMATE INC., Taipei County 248 (TW); Golden Sun News Techniques Co., Ltd., Taipei County 248 (TW)
(72) Inventor: Lin, Kuo-Len, Taipei County 248 (TW); Lin, Chen-Hsiang, Taipei County 248 (TW); Wang, Hwai-Ming, Taipei County 248 (TW); Hsu, Ken, Taipei County 248 (TW); Cheng, Chih-Hung, Taipei County 248 (TW)
(74) Representative: Urner, Peter

(56) References cited:
- EP-A- 1 921 410
- JP-A- 2001 248 982
- US-A1- 2006 144 571
- US-A1- 2008 028 610

## Description

### BACKGROUND OF THE INVENTION

### 1. Field of the Invention

The present invention relates to a heat-dissipating device, and in particular to a heat-dissipating device having a plurality of heat pipes and a process for making the same.

### 2. Description of Prior Art

Since heat pipes have many advantageous features such as large heat-conducting capacity, high heat-transferring rate, light weight, simple structure, versatility, capability of transferring large amount of heat without consuming any electricity, low price etc., they are widely used in dissipating the heat generated by electronic elements. Via the heat pipes, the heat generated by electronic heat-generating elements can be dissipated quickly, thereby overcoming the heat accumulation occurring in the electronic heat-generating elements at current stage.

Please refer to Fig. 1 representing a prior art arrangement, which is e.g. disclosed by EP 1 921 410. When the heat pipe is used in a heat-dissipating device of an electronic product, in order to transfer and dissipate the heat generated by the heat-generating elements more quickly, a plurality of heat pipes 20a is disposed on a heat-conducting base 10a to perform the heat dissipation. Thus, a plurality through slots 101a is provided at intervals on the heat-conducting base 10a, so that the evaporator sections 201a of the heat pipes 20a can be disposed in the through slots 101a respectively. Then, the heat-conducting base 10a with the evaporators 201a of the heat pipes 20a being disposed therein is adhered to a heat-generating element (not shown), so that the heat-conducting base 10a and the heat-generating element can be thermally connected with each other. Condenser sections 202a on the other side of the heat pipes 20a are provided with a plurality of heat-dissipating fins (not shown). With the large heat-conducting capacity of the heat pipe 20a, the heat generated by the heat-generating element can be transferred to each heat-dissipating fin via the heat pipes 20a, thereby dissipating the heat of the heat-generating element continuously and lowering the temperature thereof. Furthermore, with an associated heat-dissipating fan, the heat accumulated in the respective heat-dissipating fins can be dissipated quickly, thereby achieving a good heat-dissipating effect.

In the above assembly, a separating plate 102a has to be formed between each through slot 101a on the heat-conducting base 10a, so that the heat pipes 20a can be arranged on the heat-conducting base 10a at intervals. Although the separating plates 102a can allow the evaporator sections of the respective heat pipes 20a to be received in the through slots 101a, these separating plates 102a only make the evaporator sections 201a of the heat pipes 20a and the heat-generating element to be brought into a line contact but not a surface contact when the evaporator sections 201a of the heat pipes 20a are adhered to the heat-generating element. As a result, the contacting area between the evaporator sections 201a of the heat pipes 20a and the heat-generating element is reduced, and in turn, the heat-conducting effect of the heat pipes 20a on the heat-generating element is affected. Thus, the heat generated by the heat-generating element cannot be dissipated immediately.

Therefore, it is an important issue for the present Inventor to overcome the above problems.

### SUMMARY OF THE INVENTION

The present invention is to provide a process and an assembly for flush connecting evaporator sections of juxtaposed heat pipes to a fixing base, whereby the contacting area between the evaporator sections of the heat pipes and a heat-generating element can be increased so as to dissipate the heat of the heat-generating element quickly and improve the heat-conducting efficiency.

The present invention is to provide a process and an assembly for flush connecting evaporator sections of juxtaposed heat pipes to a fixing base. The process includes the steps of: a) providing a fixing base with its bottom surface having an accommodating trough; b) providing at least two heat pipes each having an evaporator section and a condenser section; c) disposing the evaporator sections of the heat pipes in the accommodating trough; and d) machining the evaporator sections of the juxtaposed heat pipes, thereby forming a plane on the evaporator sections of the heat pipe.

The present invention is to provide a process and an assembly for flush connecting evaporator sections of juxtaposed heat pipes to a fixing base. With the evaporator sections of the heat pipes being formed into a plane that is higher than or in flush with the bottom surface of the fixing base, the evaporator sections of the heat pipes can be brought into a surface contact with the heat-generating element, thereby dissipating the heat of the heat-generating element quickly.

### BRIEF DESCRIPTION OF THE DRAWINGS

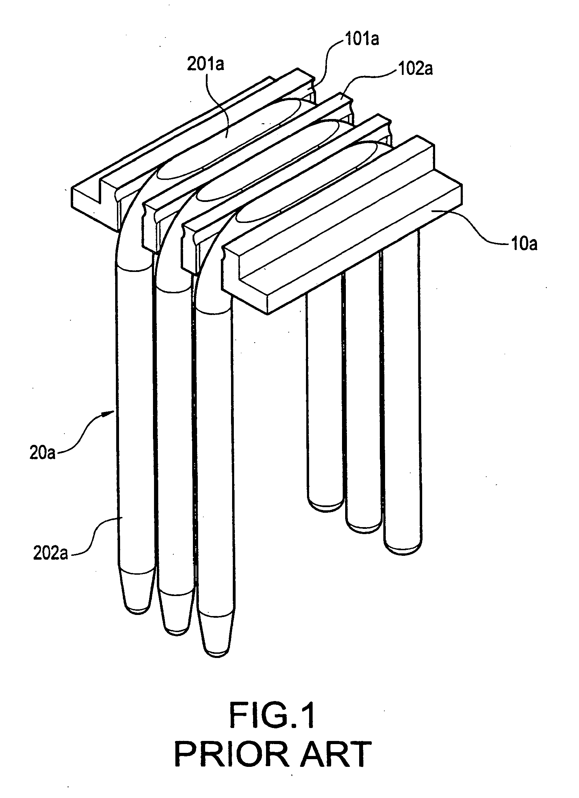

Fig. 1 is a schematic view showing the combination of heat pipes and a heat-conducting base in prior art;
Fig. 2 is a perspective view showing the external appearance of the fixing base of the present invention;
Fig. 3 is a cross-sectional view of the present invention showing the evaporator sections of two of the heat pipes being pressed in an accommodating trough;
Fig. 4 is a cross-sectional view of the present invention showing the evaporator sections of at least two heat pipes being pressed into an accommodating trough;
Fig. 5 is a schematic view showing a step of machining the evaporator sections of juxtaposed heat pipes by a die according to the present invention;
Fig. 6 is a perspective view showing the external appearance of the present invention;
Fig. 7 is an assembled cross-sectional view showing the plane formed on the evaporator sections of the heat pipes of the present invention being in flush with the bottom surface of the fixing base;
Fig. 8 is an assembled cross-sectional view showing the plane formed on the evaporator sections of the heat pipes of the present invention being higher than the bottom surface of the fixing base;
Fig. 9 is a schematic view showing the operating state of the present invention; and
Fig. 10 is a flow chart showing a process of an embodiment of the present invention.

### DETAILED DESCRIPTION OF THE INVENTION

The detailed description and technical contents of the present invention will be explained with reference to the accompanying drawings. However, the drawings are illustrative only but not used to limit the present invention.

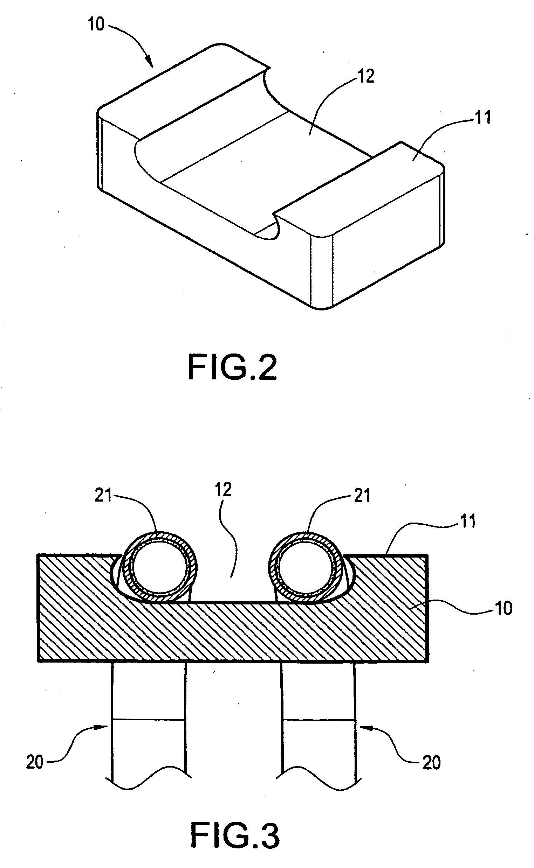

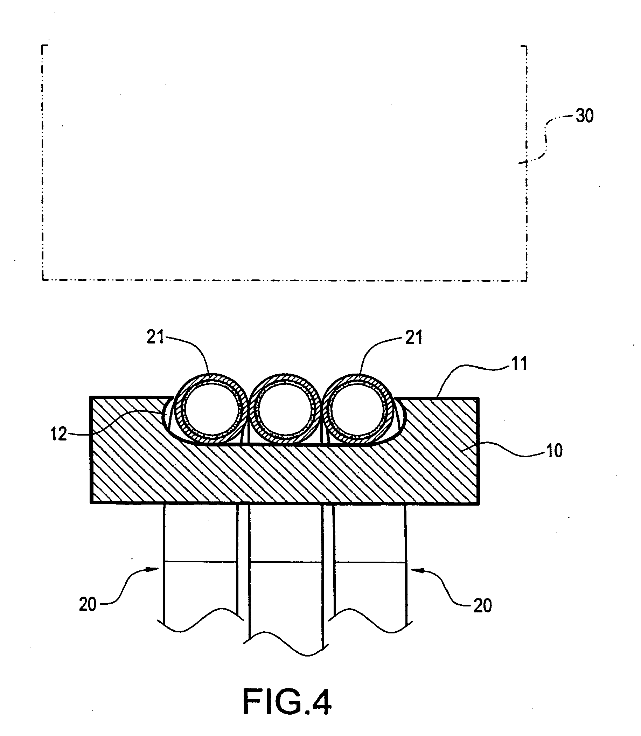

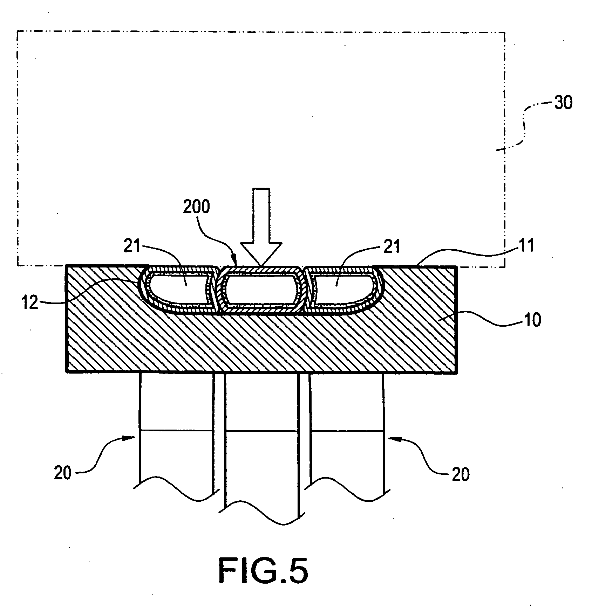

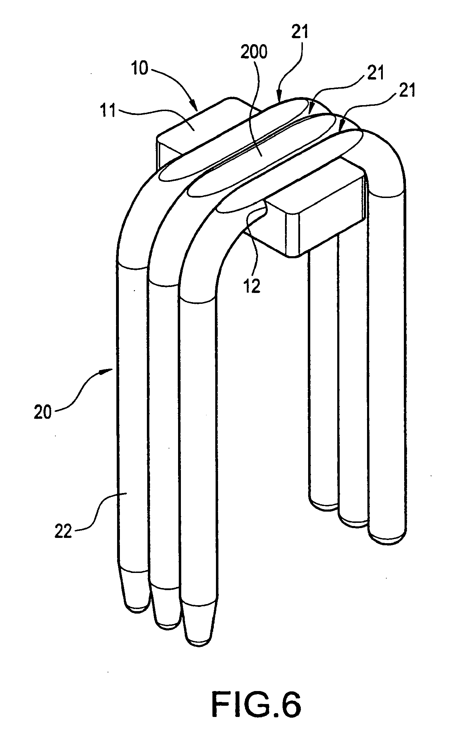

Please refer to Figs. 2 to 6. The present invention provides a process for flush connecting evaporator sections of juxtaposed heat pipes to a fixing base. First, a fixing base 10 is provided. A bottom surface 11 of the fixing base 10 is provided with an accommodating trough 12. Furthermore, at least two heat pipes 20 are provided, in which a wick structure and a working fluid are filled. In the present embodiment, there are three heat pipes 20. Next, evaporator sections 21 of the heat pipes 20 are disposed , in the accommodating trough 12. The evaporator section 21 of one of the heat pipes 20 is first disposed in the accommodating trough 12, and then the evaporator section 21 of at least one heat pipe 20 is pressed into the accommodating trough 12. In the present embodiment, the evaporator sections 21 of two of the heat pipes 20 are disposed in the accommodating trough 12, and then the evaporator section 21 of at least one heat pipe 20 is pressed into the accommodating trough 12. In practice, the evaporator sections 21 of the heat pipes 20 are juxtaposed on the accommodating trough 12, and then the evaporator sections 21 of the juxtaposed heat pipes 20 are pressed into the accommodating trough 12. Finally, via a machining step such as rolling, pressing or die-pressing, a pressing die 30 is used in the present embodiment to roll the evaporator sections 21 of the juxtaposed heat pipes 20 at least one time, so that a plane 200 can be formed on the evaporator sections 21 of the heat pipes 20. Thus, the evaporator sections 21 of the juxtaposed heat pipes 20 can be flush connected into the accommodating trough 12 of the fixing base 10.

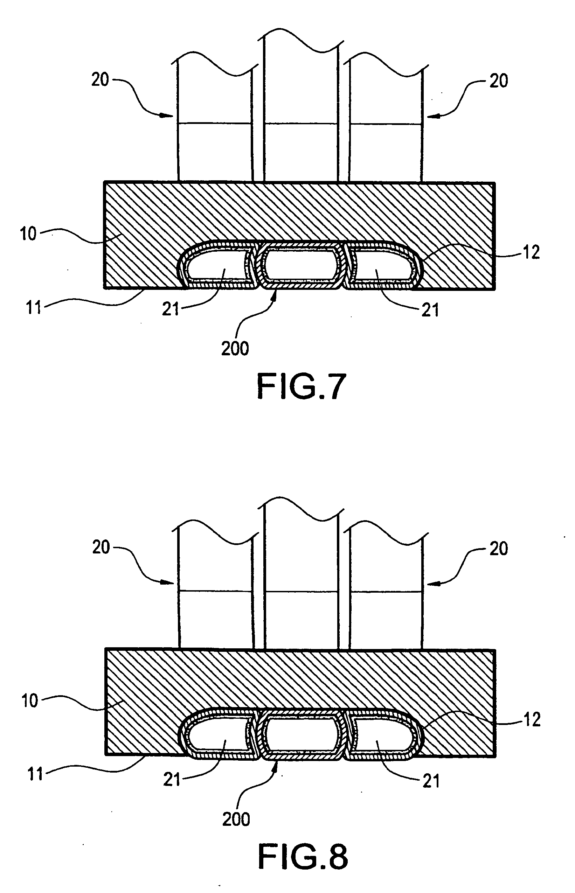

Please refer to Fig. 7, which is an assembled cross-sectional view showing the assembly for flush connecting the evaporator sections of the juxtaposed heat pipes to the fixing base according to the present invention. The bottom surface 11 of the fixing base 10 has an accommodating trough 12. The evaporator sections 21 of at least two heat pipes 20 are juxtaposed in the accommodating trough 12. In the present embodiment, three heat pipes 20 are provided. The evaporator sections 21 of the juxtaposed heat pipes 20 are machined to form a plane 200. The plane 200 formed on the evaporator sections 21 of the heat pipes 20 is in flush with the bottom surface 11 of the fixing base 10. Please refer to Fig. 8, which is different from Fig. 7 in that: after machining, the plane 200 formed on the evaporator sections 21 of the heat pipes 20 is higher than the bottom surface 11 of the fixing base 10.

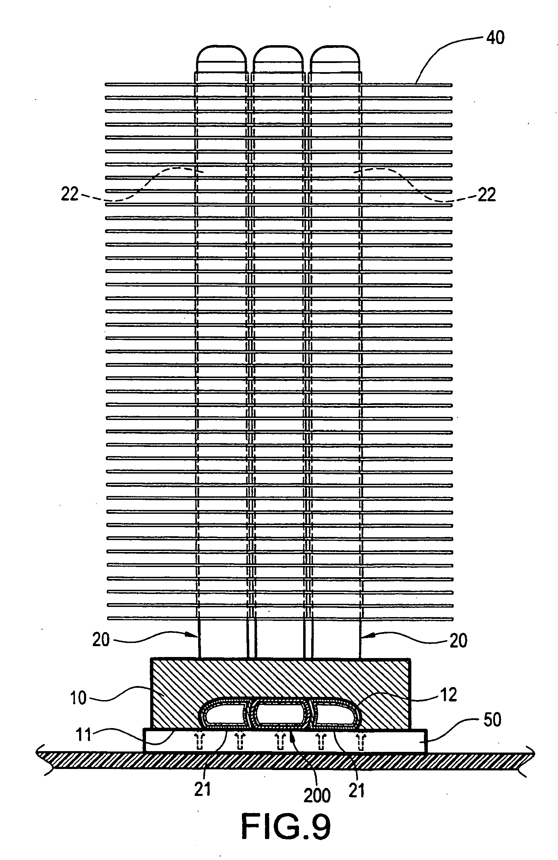

Please refer Fig. 9, which is a schematic view showing an operating state of the present invention. The evaporator sections 21 of the heat pipes 20 are machined to form a plane 200, and these heat pipes are juxtaposed flush in the accommodating trough 12 of the fixing base 10. The condenser sections22 of the heat pipes 20 are connected with a heat-dissipating fins assembly 40. In use, the plane 200 is adhered to the surface of a heat-generating element 50. In the present embodiment, the heat-generating element 50 is a CPU disposed on a circuit board. Thus, the heat generated by the heat-generating element 50 can be conducted to the evaporator sections 21 of the heat pipes 20. Then, the heat is transferred from the evaporator sections 21 of the heat pipes 20 to their condenser sections 22. Finally, the heat is transferred from the condenser sections 22 of the heat pipes 20 to the heat-dissipating fins assembly 40 having a larger heat-dissipating area. In this way, the heat generated by the heat-generating element 50 can be transferred to the heat-dissipating fins assembly 40 via the heat pipes 20, thereby dissipating the heat gradually.

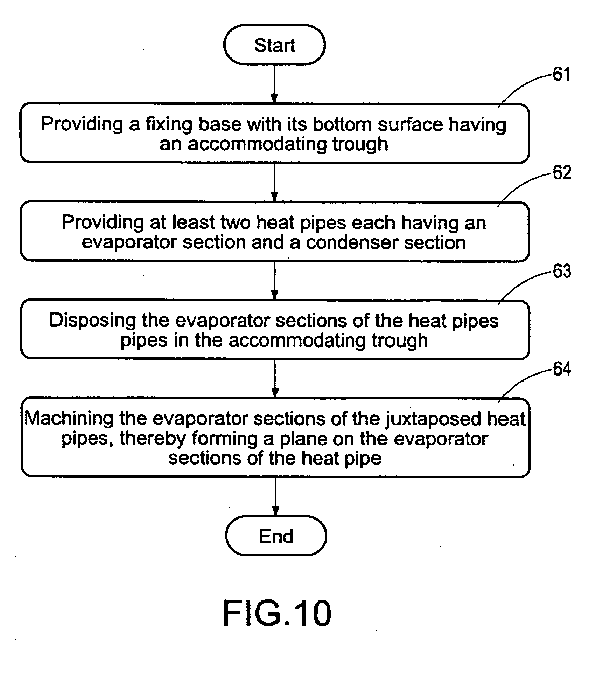

Please refer to Fig. 10, which is a flow chart showing the process for flush connecting evaporator sections of juxtaposed heat pipes to a fixing base according to the present invention (also refer to Figs. 2 to 9). The process includes the steps as follows. First, in the step 61, a fixing base 10 is provided with its bottom surface 11 having an accommodating trough 12. In the step 62, at least two heat pipes 20 each having an evaporator section 21 and a condenser section 22 are provided. Then, in the step 63, the evaporator sections 21 of the heat pipes 20 are disposed in the accommodating trough 12. Finally, in the step 64, via the machining of a rolling die 30, the evaporator sections 21 of the heat pipes 20 are rolled at least one time, thereby forming a plane 200 on the evaporator sections 21 of the heat pipes 20. The plane 200 is higher than or in flush with the bottom surface 11 of the fixing base 10. The step of disposing the evaporator sections 21 of the heat pipes 20 in the accommodating trough 12 can be performed in such a manner that the evaporator section 21 of one of the heat pipes 20 is first disposed in the accommodating trough 12, and then the evaporator sections 21 of at least one heat pipe 20 are pressed into the accommodating trough 12. In the present embodiment, the evaporator sections 21 of two of the heat pipes 20 are disposed in the accommodating trough 12, and then the evaporator section 21 of at least one heat pipes 20 is pressed into the accommodating trough 12. Alternatively, the evaporator sections 21 of the heat pipes 20 are juxtaposed on the accommodating trough 12, and then the evaporator sections 21 of the juxtaposed heat pipes 20 are pressed into the accommodating trough 12.

Therefore, according to the present invention, the evaporator sections 21 of at least two heat pipes 20 can be disposed simultaneously in the accommodating trough 12 of the fixing base 10, so that the evaporator sections 21 of the heat pipes 20 and the heat-generating element 50 can be brought into a surface contact, thereby increasing the contact area between the evaporator sections 21 of the heat pipes 20 and the heat-generating element 50. In this way, the heat of the heat-generating element 50 can be dissipated quickly and the heat-conducting efficiency can be improved.

## Claims

1. A process for flush connecting evaporator sections (21) of juxtaposed heat pipes (20) to a fixing base (10), comprising the steps of:
a) providing a fixing base (10) with a bottom surface (11) thereof having an accommodating trough (12);
b) providing at least two heat pipes (20) each having an evaporator section (21) and a condenser section (22);
c) disposing the evaporator sections (21) of the heat pipes (20) in the accommodating trough (12); and
d) machining the evaporator sections (21) of the juxtaposed heat pipes (20), thereby forming a plane (200) on the evaporator sections (21) of the heat pipe (20).

2. The process for flush connecting evaporator sections (21) of juxtaposed heat pipes (20) to a fixing base (10) according to claim 1, wherein the step (b) is performed by providing at least three heat pipes (20).

3. The process for flush connecting evaporator sections (21) of juxtaposed heat pipes (20) to a fixing base (10) according to claim 2, wherein the step (c) is performed by first disposing the evaporator sections (21) of two of the heat pipes (20) in the accommodating trough (12), and then pressing the evaporator sections (21) of at least one heat pipe (20) in the accommodating trough (12).

4. The process for flush connecting evaporator sections (21) of juxtaposed heat pipes (20) to a fixing base (10) according to claim 1, wherein the step (c) is performed by first disposing the evaporator section (21) of one of the heat pipes (20) in the accommodating trough (12), and then pressing the evaporator sections (21) of at least one heat pipe (20) in the accommodating trough (12).

5. The process for flush connecting evaporator sections (21) of juxtaposed heat pipes (20) to a fixing base (10) according to claim 1, wherein the step (c) is performed by first juxtaposing the evaporator sections (21) of the heat pipes (20) on the accommodating trough (12), and then pressing the evaporator sections (21) of the juxtaposed heat pipes (20) in the accommodating trough (12).

6. The process for flush connecting evaporator sections (21) of juxtaposed heat pipes (20) to a fixing base (10) according to claim 1, wherein the machining step is performed by rolling, pressing or die-pressing.

7. The process for flush connecting evaporator sections (21) of juxtaposed heat pipes (20) to a fixing base (10) according to claim 1, wherein the plane (200) formed on the evaporator sections (21) of the heat pipes (20) is higher than the bottom surface (11) of the fixing base (10).

8. The process for flush connecting evaporator sections (21) of juxtaposed heat pipes (20) to a fixing base (10) according to claim 1, wherein the plane (200) formed on the evaporator sections (21) of the heat pipes (20) is in flush with the bottom surface (11) of the fixing base (10).

9. The process for flush connecting evaporator sections (21) of juxtaposed heat pipes (20) to a fixing base (10) according to claim 1, wherein the evaporator sections (21) of the heat pipes (20) are machined at least one time.

10. An assembly for flush connecting evaporator sections (21) of juxtaposed heat pipes (20) to a fixing base (10), comprising:
a fixing base (10) with a bottom surface (11) thereof having an accommodating trough (12); and
at least two heat pipes (20) each having an evaporator section (21) and a condenser section (22), the evaporator sections (21) of the heat pipes (20) being juxtaposed in the accommodating trough (12),
wherein a surface of the evaporator sections (21) of the juxtaposed heat pipes (20) is machined to form a plane (200) that is not lower than the bottom surface (11) of the fixing base (10).

11. The assembly for flush connecting evaporator sections (21) of juxtaposed heat pipes (20) to a fixing base (10) according to claim 10, wherein the plane (200) formed on the evaporator sections (21) of the heat pipes (20) is higher than the bottom surface (11) of the fixing base (10).

12. The assembly for flush connecting evaporator sections (21) of juxtaposed heat pipes (20) to a fixing base (10) according to claim 10, wherein the plane (200) formed on the evaporator sections (21) of the heat pipes (20) is in flush with the bottom surface (11) of the fixing base (10).

## Patentansprüche

1. Verfahren zum bündigen Verbinden von Verdampferabschnitten (21) von nebeneinander liegenden Heizrohren (20) mit einer Befestigungsbasis (10), das die folgenden Schritte umfasst:
a) Vorsehen einer Befestigungsbasis (10) mit einer unteren Oberfläche, die eine Aufnahmewanne (12) besitzt;
b) Vorsehen von wenigstens zwei Heizrohren (20), wovon jedes einen Verdampferabschnitt (21) und einen Kondensatorabschnitt (22) besitzt;
c) Anordnen der Verdampferabschnitte (21) der Heizrohre (20) in der Aufnahmewanne (12); und
d) maschinelles Bearbeiten der Verdampferabschnitte (21) der nebeneinander liegenden Heizrohre (20), um **dadurch** eine Ebene (200) auf den Verdampferabschnitten (21) des Heizrohrs (20) zu bilden.

2. Verfahren zum bündigen Verbinden von Verdampferabschnitten (21) von nebeneinander liegenden Heizrohren (20) mit einer Befestigungsbasis (10) nach Anspruch 1, wobei der Schritt (b) durch Vorsehen von wenigstens drei Heizrohren (20) ausgeführt wird.

3. Verfahren zum bündigen Verbinden von Verdampferabschnitten (21) von nebeneinander liegenden Heizrohren (20) mit einer Befestigungsbasis (10) nach Anspruch 2, wobei der Schritt (c) **dadurch** ausgeführt wird, dass zunächst die Verdampferabschnitte (21) von zwei der Heizrohre (20) in der Aufnahmewanne (12) angeordnet werden und dann die Verdampferabschnitte (21) wenigstens eines Heizrohrs (20) in die Aufnahmewanne (12) gepresst werden.

4. Verfahren zum bündigen Verbinden von Verdampferabschnitten (21) von nebeneinander liegenden Heizrohren (20) mit einer Befestigungsbasis (10) nach Anspruch 1, wobei der Schritt (c) **dadurch** ausgeführt wird, dass zunächst der Verdampferabschnitt (21) eines der Heizrohre (20) in der Aufnahmewanne (12) angeordnet wird und dann die Verdampferabschnitte (21) wenigstens eines Heizrohrs (20) in die Aufnahmewanne (12) gepresst wird.

5. Verfahren zum bündigen Verbinden von Verdampferabschnitten (21) von nebeneinander liegenden Heizrohren (20) an einer Befestigungsbasis (10) nach Anspruch 1, wobei der Schritt (c) **dadurch** ausgeführt wird, dass zunächst die Verdampferabschnitte (21) der Heizrohre (20) nebeneinander auf die Aufnahmewanne (12) gelegt werden und dann die Verdampferabschnitte (21) der nebeneinander liegenden Heizrohre (20) in die Aufnahmewanne (12) gepresst werden.

6. Verfahren zum bündigen Verbinden von Verdampferabschnitten (21) von nebeneinander liegenden Heizrohren (20) mit einer Befestigungsbasis (10) nach Anspruch 1, wobei der Schritt des maschinellen Bearbeitens durch Walzen, Pressen oder Warmpressen ausgeführt wird.

7. Verfahren zum bündigen Verbinden von Verdampferabschnitten (21) von nebeneinander liegenden Heizrohren (20) mit einer Befestigungsbasis (10) nach Anspruch 1, wobei die Ebene (200), die auf den Verdampferabschnitten (21) der Heizrohre (20) gebildet wird, höher ist als die untere Oberfläche (11) der Befestigungsbasis (10).

8. Verfahren zum bündigen Verbinden von Verdampferabschnitten (21) von nebeneinander liegenden Heizrohren (20) mit einer Befestigungsbasis (10) nach Anspruch 1, wobei die Ebene (200), die auf den Verdampferabschnitten (21) der Heizrohre (20) gebildet wird, mit der unteren Oberfläche (11) der Befestigungsbasis (10) bündig ist.

9. Verfahren zum bündigen Verbinden von Verdampferabschnitten (21) von nebeneinander liegenden Heizrohren (20) mit einer Befestigungsbasis (10) nach Anspruch 1, wobei die Verdampferabschnitte (21) der Heizrohre (20) wenigstens einmal maschinell bearbeitet werden.

10. Anordnung zum bündigen Verbinden von Verdampferabschnitten (21) von nebeneinander liegenden Heizrohren (20) mit einer Befestigungsbasis (10), die umfasst:
eine Befestigungsbasis (10) mit einer unteren Oberfläche (11), die eine Aufnahmewanne (12) besitzt; und
wenigstens zwei Heizrohre (20), wovon jedes einen Verdampferabschnitt (21) und einen Kondensatorabschnitt (22) besitzt, wobei die Verdampferabschnitte (21) der Heizrohre (20) in der Aufnahmewanne (12) nebeneinander liegen,
wobei eine Oberfläche der Verdampferabschnitte (21) der nebeneinander liegenden Heizrohre (20) maschinell bearbeitet ist, um eine Ebene (200) zu bilden, die nicht niedriger ist als die untere Oberfläche (11) der Befestigungsbasis (10).

11. Anordnung zum bündigen Verbinden von Verdampferabschnitten (21) von nebeneinander liegenden Heizrohren (20) mit einer Befestigungsbasis (10) nach Anspruch 10, wobei die Ebene (200), die auf den Verdampferabschnitten (21) der Heizrohre (20) gebildet ist, höher ist als die untere Oberfläche (11) der Befestigungsbasis (10).

12. Anordnung zum bündigen Verbinden von Verdampferabschnitten (21) von nebeneinander liegenden Heizrohren (20) mit einer Befestigungsbasis (10) nach Anspruch 10, wobei die Ebene (200), die auf den Verdampferabschnitten (21) der Heizrohre (20) gebildet ist, mit der unteren Oberfläche (11) der Befestigungsbasis (10) bündig ist.

## Revendications

1. Procédé pour connecter en alignement des sections d'évaporateur (21) de caloducs juxtaposés (20) sur une base de fixation (10), comprenant les étapes consistant à :
a) fournir une base de fixation (10) telle qu'une surface inférieure (11) de celle-ci présente une auge de logement (12) ;
b) fournir au moins deux caloducs (20), ayant chacun une section d'évaporateur (21) et une section de condenseur (22) ;
c) disposer les sections d'évaporateur (21) des caloducs (20) dans l'auge de logement (12) ; et
d) usiner les sections d'évaporateur (21) des caloducs juxtaposés (20), en formant ainsi un plan (200) sur les sections d'évaporateur (21) du caloduc (20).

2. Procédé pour connecter en alignement des sections d'évaporateur (21) de caloducs juxtaposés (20) sur une base de fixation (10) selon la revendication 1, dans lequel l'étape (b) est mise en oeuvre en fournissant au moins trois caloducs (20).

3. Procédé pour connecter en alignement des sections d'évaporateur (21) de caloducs juxtaposés (20) sur une base de fixation (10) selon la revendication 2, dans lequel l'étape (c) est mise en oeuvre en disposant en premier lieu les sections d'évaporateur (21) de deux des caloducs (20) dans l'auge de logement (12), puis en pressant les sections d'évaporateur (21) d'au moins un caloduc (20) dans l'auge de logement (12).

4. Procédé pour connecter en alignement des sections d'évaporateur (21) de caloducs juxtaposés (20) sur une base de fixation (10) selon la revendication 1, dans lequel l'étape (c) est mise en oeuvre en disposant en premier lieu la section d'évaporateur (21) de l'un des caloducs (20) dans l'auge de logement (12), puis en pressant les sections d'évaporateur (21) d'au moins un caloduc (20) dans l'auge de logement (12).

5. Procédé pour connecter en alignement des sections d'évaporateur (21) de caloducs juxtaposés (20) sur une base de fixation (10) selon la revendication 1, dans lequel l'étape (c) est mise en oeuvre en juxtaposant en premier lieu les sections d'évaporateur (21) des caloducs (20) sur l'auge de logement (12), puis en pressant les sections d'évaporateur (21) des caloducs juxtaposés (20) dans l'auge de logement (12).

6. Procédé pour connecter en alignement des sections d'évaporateur (21) de caloducs juxtaposés (20) sur une base de fixation (10) selon la revendication 1, dans lequel l'étape d'usinage est exécutée par galetage, par pressage ou par pressage en matrice.

7. Procédé pour connecter en alignement des sections d'évaporateur (21) de caloducs juxtaposés (20) sur une base de fixation (10) selon la revendication 1, dans lequel le plan (200) formé sur les sections d'évaporateur (21) des caloducs (20) est plus haut que la surface inférieure (11) de la base de fixation (10).

8. Procédé pour connecter en alignement des sections d'évaporateur (21) de caloducs juxtaposés (20) sur une base de fixation (10) selon la revendication 1, dans lequel le plan (200) formé sur les sections d'évaporateur (21) des caloducs (20) est en alignement avec la surface inférieure (11) de la base de fixation (10).

9. Procédé pour connecter en alignement des sections d'évaporateur (21) de caloducs juxtaposés (20) sur une base de fixation (10) selon la revendication 1, dans lequel les sections d'évaporateur (21) des caloducs (20) sont usinées au moins une fois.

10. Assemblage pour connecter en alignement des sections d'évaporateur (21) de caloducs juxtaposés (20) sur une base de fixation (10), comprenant :
une base de fixation (10) dont une surface inférieure (11) comporte une auge de logement (12) ; et
au moins deux caloducs (20) ayant chacun une section d'évaporateur (21) et une section de condenseur (22), les sections d'évaporateur (21) des caloducs (20) étant juxtaposées dans l'auge de logement (12),
dans lequel une surface des sections d'évaporateur (21) des caloducs juxtaposés (20) est usinée pour former un plan (200) qui n'est pas plus bas que la surface inférieure (11) de la base de fixation (10).

11. Assemblage pour connecter en alignement des sections d'évaporateur (21) de caloducs juxtaposés (20) sur une base de fixation (10) selon la revendication 10, dans lequel le plan (200) formé sur les sections d'évaporateur (21) des caloducs (20) est plus haut que la surface inférieure (11) de la base de fixation (10).

12. Assemblage pour connecter en alignement des sections d'évaporateur (21) de caloducs juxtaposés (20) sur une base de fixation (10) selon la revendication 10, dans lequel le plan (200) formé sur les sections d'évaporateur (21) des caloducs (20) est en alignement avec la surface inférieure (11) de la base de fixation (10).
